# EUROPEAN PATENT SPECIFICATION

(11) **EP 2 084 896 B1**
(45) Date of publication and mention of the grant of the patent: **29.10.2014**
(21) Application number: 07840058.7
(22) Date of filing: 15.11.2007
(51) Int. Cl.: H01L 27/146, G02B 27/00, H04N 5/225

(54) **CONTROL OF STRAY LIGHT IN CAMERA SYSTEMS EMPLOYING AN OPTICS STACK AND ASSOCIATED METHODS**
STEUERUNG VON STREULICHT IN KAMERASYSTEMEN MIT EINEM OPTIKSTAPEL UND ENTSPRECHENDE VERFAHREN
RÉGULATEUR DE LUMIÈRE PARASITE DANS DES SYSTÈMES DE CAMÉRA UTILISANT UN EMPILEMENT D'ÉLÉMENTS OPTIQUES, ET PROCÉDÉS ASSOCIÉS

(30) Priority: 16.11.2006 US 600282
(43) Date of publication of application: 05.08.2009
(73) Proprietor: DigitalOptics Corporation, San Jose, CA 95134 (US)
(72) Inventor: TEKOLSTE, Robert D., Charlotte, NC 28262 (US); MCWILLIAMS, Bruce, San Jose, CA 95134 (US); HAN, Hongtao, Charlotte, NC 28262 (US); WELCH, Hudson, Charlotte, NC 28262 (US)
(74) Representative: Zacco Denmark A/S
(86) International application number: PCT/US2007/023961
(87) International publication number: WO 2008/063528

(56) References cited:
- EP-A- 1 441 509
- WO-A-2004/027880
- WO-A-2008/011003
- JP-A- 9 329 818
- US-A1- 2005 146 800

## Description

### 1. Field of the Invention

The present invention is directed to a camera system and associated methods. More particularly, the present invention is directed to a camera system including an optics stack having reduced stray light.

### 2. Background of the Invention

Cameras may include an optics stack of optical substrates secured to one another at planar portions thereof. A plurality of these optics stacks may be made simultaneously, e.g., at a wafer level.

Further, since the optical system may be formed of a vertical stack of substrates secured to one another, a housing, e.g., a barrel, may not be needed for mounting lenses in the optical system. While elimination of such a housing may provide many advantages, including increased simplicity and reduced cost, such an optical system itself may have transparent sides along which the stack was separated, e.g., diced, from a rest of a wafer.

Such sides may allow light to enter the optics stack at other than the designed entrance pupil and/or may allow light incident at high angles on the designed entrance pupil to be reflected from an edge onto the sensor. In other words, light entering from the sides externally may increase noise and/or light reflected internally from the sides may increase noise.

WO 2004/027880 A2 discloses a camera system comprising an optics stack including two lens substrates.

EP 1148 716 A1 discloses an imaging device comprising an optical element attached to a detector substrate wherein a light-shielding resin is employed as the sealing resin.

### SUMMARY OF THE INVENTION

The present invention is therefore directed to a camera system employing an optics stack and associated methods, which substantially overcome one or more of the problems due to the limitations and disadvantages of the related art.

It is therefore a feature of the present invention to provide a material preventing external stray light from reaching a detector of the camera system.

It is another feature of the present invention to provide a material preventing internally reflected stray light from reaching the detector of the camera system.

At least one of the above and other features and advantages of the present invention are obtained by providing a camera system, including an optics stack including two substrates secured together in a vertical direction and an optical system on the two substrates, the two substrates having transparent sides, a detector on a detector substrate, and a stray light blocker directly on at least some sides of the optics stack.

The at least some sides may include sides on a substrate in the optics stack furthest away from the detector substrate. The stray light blocker may be on all sides of the optics stack.

The stray light blocker may have an index of refraction that is approximately equal to that of a substrate having the at least some sides. The stray light blocker includes an encapsulant. The stray light blocker may be opaque to wavelengths the detector can detect.

One substrate in the optics stack may have a smaller surface area than the detector substrate. The substrates in the optics stack may be coextensive.

The detector substrate may extend beyond the optics stack in at least one direction. Bonding pads may be on the detector substrate extending beyond the optics stack. The camera system may include a substrate having elements to be electrically connected to the bonding pads.

The stray light blocker includes an encapsulant extend which may from an upper surface of the optics stack to the detector substrate. The encapsulant may cover the bonding pads and electrical connectors between the bonding pads and the substrate. The camera system may include features on the substrate restraining the encapsulant.

The camera system includes a housing surrounding the optics stack. The detector substrate may extend beyond the optics stack in at least one direction. Bonding pads may be on the detector substrate extending beyond the optics stack. The camera system may include a substrate having elements to be electrically connected to the bonding pads. The housing surrounding the optics stack may extend down to the substrate.

Substrates in the optics stack may not be coextensive. The housing may extend to cover an upper portion of the optics stack extending beyond other substrates. The stray light blocker includes an encapsulant which may be present between an opening in an upper surface of the housing and the upper portion of the optics stack extending beyond other substrates. The stray light blocker includes an encapsulant between the housing and the optics stack.

Substrates in the optics stack may not be coextensive. The stray light blocker includes an encapsulant along the optics stack.

A spacer separating the substrates in the optics stack may include a gap from the exposed sides. The stray light blocker includes an encapsulant along the optics stack, the encapsulant optionally filling the gap.

Electrical interconnections may be provided through the detector substrate.

A cover plate on a detector substrate may extend beyond the optics stack in at least one direction. An opaque material may be on an exposed surface of the cover plate. The opaque material is the same as the stray light blocker. The cover plate may have an angled edge and the camera system may comprise an opaque material covering the angled edge of the cover plate. The opaque material is the same as the stray light blocker.

### BRIEF DESCRIPTION OF THE DRAWINGS

The above and other features and advantages of the present invention will become more apparent to those of ordinary skill in the art by describing in detail exemplary embodiments thereof with reference to the attached drawings, in which:
FIG. 1 illustrates a cross-sectional view of a camera system in accordance with a first exemplary embodiment of the present invention;
FIG. 2 illustrates a cross-sectional view of a camera system in accordance with a second exemplary embodiment lying outside the scope of the present invention;
FIG. 3 illustrates a cross-sectional view of a camera system in accordance with a third exemplary embodiment of the present invention;
FIG. 4 illustrates a cross-sectional view of a camera system in accordance with a fourth exemplary embodiment lying outside the scope of the present invention;
FIG. 5 illustrates a cross-sectional view of a camera system in accordance with a fifth exemplary embodiment of the present invention;
FIG. 6 illustrates a cross-sectional view of a camera system in accordance with a sixth exemplary embodiment of the present invention;
FIG. 7 illustrates a cross-sectional view of camera system in accordance with a seventh exemplary embodiment lying outside the scope of the present invention;
FIG. 8 illustrates a cross-sectional view of a camera system in accordance with an eighth exemplary embodiment of the present invention; and
FIG. 9 illustrates a schematic elevational view of a camera system describing stray light issues generally.

### DETAILED DESCRIPTION

The present invention will now be described more fully hereinafter with reference to the accompanying drawings, in which preferred embodiments are shown.

In the drawings, the thickness of layers and regions may be exaggerated for clarity. It will also be understood that when a layer is referred to as being "on" another layer or substrate, it may be directly on the other layer or substrate, or intervening layers may also be present. Further, it will be understood that when a layer is referred to as being "under" another layer, it may be directly under, or one or more intervening layers may also be present. In addition, it will also be understood that when a layer is referred to as being "between" two layers, it may be the only layer between the two layers, or one or more intervening layers may also be present. Like numbers refer to like elements throughout. As used herein, the term "wafer" is to mean any substrate on which a plurality of components are formed which are to be vertically separated prior to final use. Further, as used herein, the term "camera system" is to mean any system including an optical imaging system relaying optical signals to a detector, e.g., an image capture system, which outputs information, e.g., an image.

In accordance with embodiments of the present invention, a camera system utilizing lenses includes an optics stack having at least two substrates secured on a wafer level. The optics stack includes an optical imaging system. Substrates on which the optical imaging system is formed may have transparent edges that may be exposed, which may increase stray light reaching the detector, increasing noise. By providing a blocking material on at least some of the edges, this stray light may be reduced or eliminated.

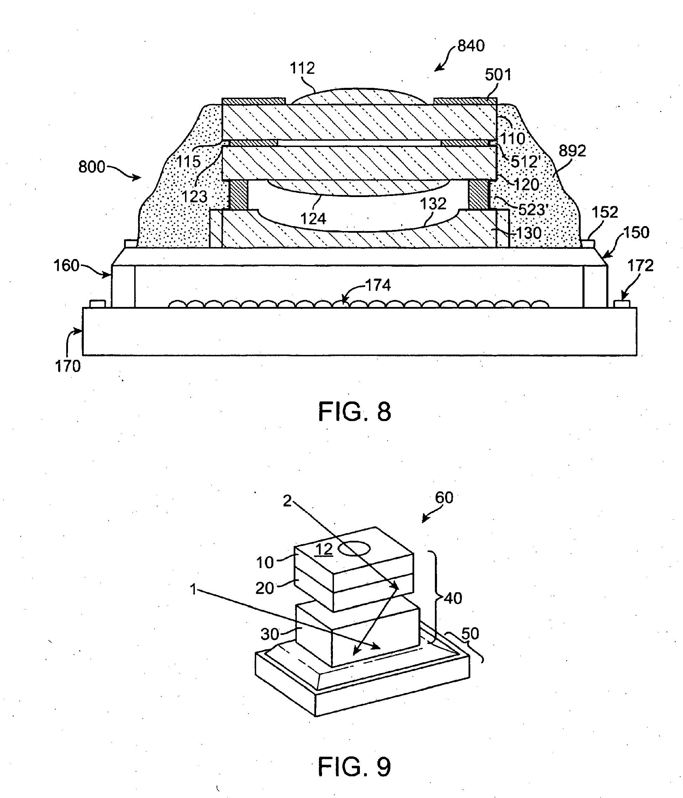

As shown in the elevational schematic view of FIG. 9, a camera system 60 may include an optics stack 40 and a sealed detector 50. The optical stack 40 may include a first transparent substrate 10, a second transparent substrate 20, and a third transparent substrate 30. A light blocking material 12 may be provided on an upper surface of the first transparent substrate 10 to define an entrance pupil and block stray light from entering the camera system 60. However, remaining transparent surfaces of the optics stack 40 may allow light to enter the optics stack 40 at other than the designed entrance pupil and/or may allow light incident at high angles on the designed entrance pupil to be reflected from an edge onto the detector. For example, a light beam 1 may enter the optics stack 40 from a side externally and/or a light beam 2 may be reflected internally from a side of the optics stack 40, either of which may increase noise in the camera system 60. These problems may be exacerbated as a size of the optical substrates on which the optical system is formed is reduced and as the sides get closer to the sensor.

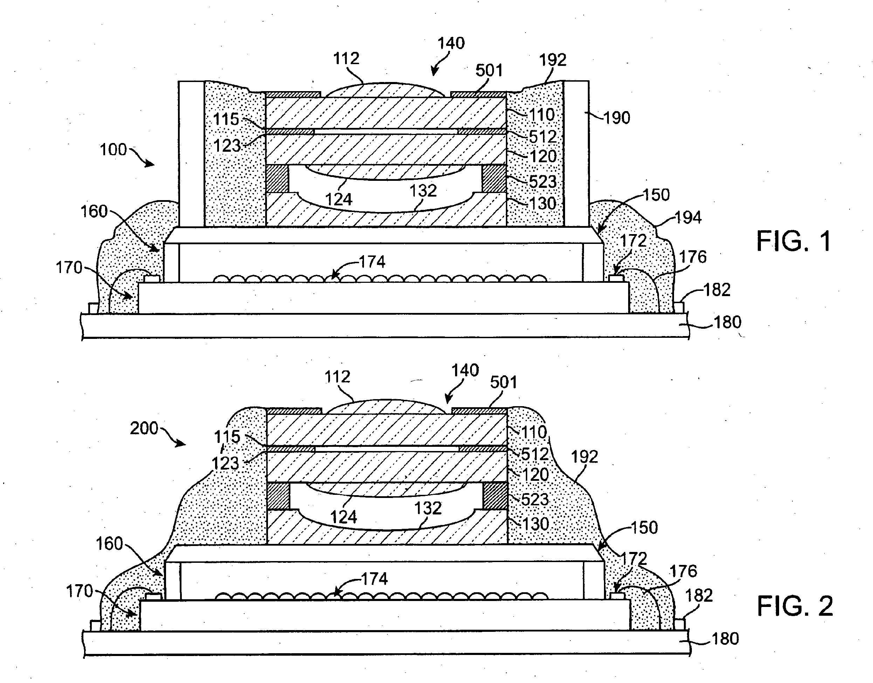

A camera system 100 in accordance with the first embodiment of the present invention is shown in FIG. 1. In FIG. 1, a single lens system may be used for all colors, and a color filter may be provided directly on a detector array. Alternatively, this lens system may be provided in any number, e.g., three or four, of sub-cameras for each camera system, while a design and/or location of the color filters may be varied. Such lens stack designs for a camera may be found, for example, in commonly assigned, co-pending U.S. Provisional Patent Application No. 60/855,365 filed October 31, 2006 and U.S. Patent Application Nos. 11/487,580, filed July 17, 2006, and 10/949,807, filed September 27, 2004.

As illustrated in FIG. 1, the camera system 100 according to the first embodiment of the present invention includes an optics stack 140 and a detector substrate 170. The optics stack 140 may include a first substrate 110, a second substrate 120 and a third substrate 130, secured together by respective spacers 512 and 523. An additional spacer 501 may be provided on the first substrate 110 to serve as an aperture stop for the optics stack 140.

The first substrate 110 may include a first refractive convex surface 112, which may assist in imaging the light input thereto. A second surface 114 of the first substrate 110 may be planar, and may include an infrared filter 115 thereon. The infrared filter 115 may be on any of the surfaces in the optics stack 140

A first surface of the second substrate 120 may have a diffractive element 123 thereon, which may correct for color and camera aberrations. A second surface of the second substrate 120 may have a second refractive convex surface 124, which may further assist in imaging the light.

The third substrate 130 may have a refractive, concave surface 132 therein. The concave surface 132 may flatten the field of the image, so that all image points may be imaged at the same plane onto an active area of a detector array on the detector substrate 170.

A cover plate 150 and a standoff 160, providing accurate spacing between the optics stack 140 and the detector substrate 170, may be provided between the optics stack 140 and the detector substrate 170. The cover plate 150 and the standoff 160 may seal the active area. In addition to the active area, the detector substrate 170 may include an array of microlenses 174 and bond pads 172.

While the standoff 160 is illustrated as being a separate element from the detector substrate 170 and the cover plate 150, the standoff 160 may be integral with either one or both of the detector substrate 170 and the cover plate 150. Further, while sidewalls of the standoff 160 are shown as being straight, e.g., formed by dicing or patterning, they may be angled in accordance with how the standoff 160 is formed, e.g., at an etch angle of a.particular material used for the standoff 160. Finally, the standoff 160 may be an adhesive material that is precisely provided on one or both of the detector substrate 170 and the cover plate 150, e.g., as disclosed in commonly assigned U.S. Patent No. 6,669,803.

Similarly, while the cover plate 150 is illustrated as having beveled edges, this may be an artifact of a process used to create the cover plate 150, and may vary in accordance with different processes. In particular, when elements below a surface to be diced are to be protected, e.g., the dicing is not to occur through all secured wafers, an angled dicing blade may be employed. Further, the cover plate 150 may be transparent to light, e.g., glass, to be recorded by the camera system 100.

As shown in FIG. 1, the substrates 110, 120 and 130 may have opposing planar surfaces with the optical elements 112, 115, 123, 124 and 132 formed therebetween. The use of planar surfaces may be advantageous, since it may enable control of the tilt of all of the elements in the lens system. The use of planar surfaces may also allow stacking of the elements and bonding directly to the planar surfaces, which may facilitate wafer level assembly. The planar surfaces may be left in the periphery around each element, or planar surfaces may be formed around the periphery of each lens element through deposition of suitable material.

Substrates in the optics stack 140 have optical elements thereon are transparent to wavelengths being imaged. Without additional structure, the edges of the substrates are exposed. Thus, as noted above, external stray light may enter through edges of these substrates, even with the opaque spacers, and may impinge of the active area. Additionally, light entering at high angles, i.e., outside the field of view of the camera, may be internally reflected at these edges and may impinge of the active area. However, by providing a light blocking material on the edges, the amount of stray light reaching the active area may be reduced.

In the first embodiment shown in FIG. 1, the light blocking material is an encapsulant 192, which is contained by a housing 190. Unlike housings used in designs not incorporating optics stacks, the housing 190 is very simple, and the optical elements are not secured directly thereto. The housing 190 may be opaque. The encapsulant 192 may be opaque, and may have a refractive index similar to that of the material of the substrates of the optics stack. For example, when the substrates are fused silica, having a refractive index of around 1.5, the encapsulant 192 may be a silicone gel sealant, e.g., HIPEC® R6102 SEMICONDUCTOR PROTECTIVE COATING from Dow Corning Corporation. Depending on a thickness of the encapsulant to be used, this known encapsulant may not be opaque enough. Therefore, material, e.g., carbon, may be added to this conventional encapsulant to make the conventional encapsulant more opaque. The encapsulant 192 may have a low modulus, i.e., may not induce much stress on the other elements, e.g., may avoid breaking of the wire bonds 176. While an opaque or absorptive material as the encapsulant 192 may reduce external light from entering the optics stack 140 other than at the entrance pupil, using a material that has a similar refractive index to that of the edges may reduce internal reflections within the optics stack 140.

After the pads 172 have been electrically connected to another substrate 180, e.g., a chip on board (COB), via wire bonds 176, an encapsulant 194 may be provided to protect the wire bonds 176. The substrate 180 may include features 182 thereon, e.g., a perimeter, to restrain the encapsulant 194. These features may be formed lithographically in or on the substrate, and may be at least 50 microns high. The encapsulant 194 may be the same as or different from the encapulant 192. The encapsulants 192, 194 may be provided simultaneously or sequentially.

Depending on the viscosity of an encapsulant material being used, the encapsulant material may be provided over an entire wafer of camera systems in manners similar to those used for bonding materials. For example, the encapsulant material may be provided sequentially, as set forth, for example, in U.S. Patent No. 6,096,155, or simultaneously, as set forth, for example, in U.S. Patent 6,669,803. If the encapsulant material is provided simultaneously, some mask protecting an upper surface of the optics stack 140 may be employed. Other techniques, such as using a syringe or injection molding, may be used. Further, good coverage may require a multi-step process of applying the encapsulant, e.g., repeating appying and curing of the encapsulant.

In a camera system 200 according to the second embodiment lying outside the scope of the present invention, as illustrated in FIG. 2, the housing 190 may be eliminated, and the same encapsulant 192 may be used to both reduce stray light in the optics stack 140 and protect wire bonds 176. Other elements of the second embodiment are the same as those in the first embodiment, and detailed description thereof is omitted.

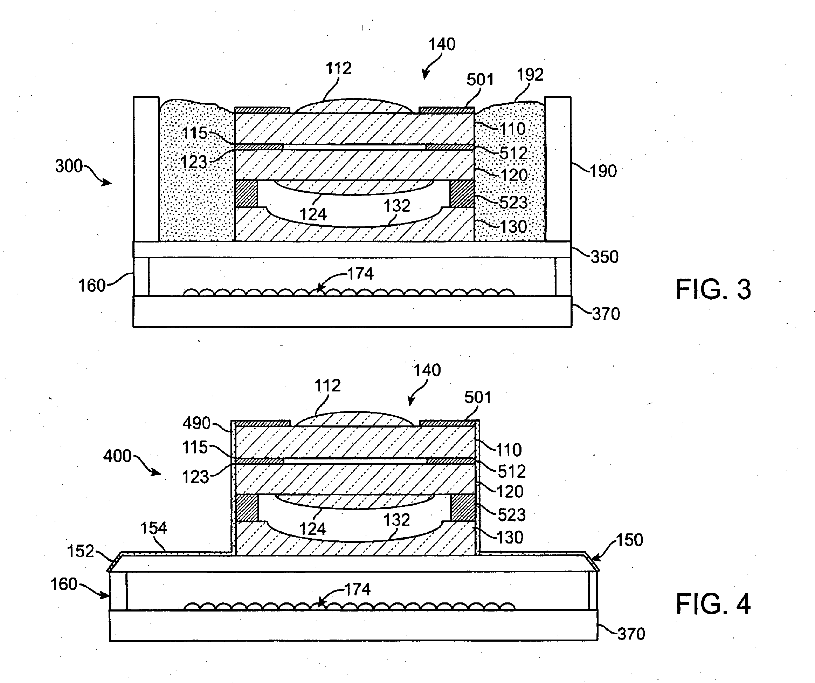

In a camera system 300 according to the third embodiment, a detector substrate 370 may be configured to be surface mounted, e.g., using a ball grid array, to another substrate, thus eliminating wire bonds. However, the same housing 190 and encapsulant 192 illustrated in FIG. 1 are still employed. Further, as shown in FIG. 3, edges of a cover plate 350 may be vertical. Also, as shown in FIG. 3, the housing 190, the cover plate 350 and the detector substrate 370 may be co-extensive. Other elements of the third embodiment are the same as those in the first embodiment, and detailed description thereof is omitted.

In a camera system 400 according to the fourth embodiment lying outside the scope of the present invention, as illustrated in FIG. 4, a coating 490 may replace the housing 190 and the encapsulant 192 of the third embodiment. The coating 490 may have similar properties as those of the encapsulant 192, i.e., be opaque and have a similar refractive index as the substrates, and may be the same material as the encapsulant 192.

As used herein, the term "coating" is to mean a material having substantially controlled thickness on a surface, and "encapsulant" is to mean a material that is conformally deposited. The coating 490 may be formed by evaporation, painting, immersion in, e.g., a liquid ink, etc. The coating 490 may be used even when the optics stack 140 is coextensive with the detector substrate 470.

When the coated optics stack 140, 490 is not coextensive with the detector substrate 470 or with the cover plate 150, as shown in FIG. 4, a light shielding element 154 may also be provided on the cover plate 150, e.g., the same material as used for the coating 490 or a different material, e.g., a metal. Further, a light shielding element 152 may be provided on the beveled edge, and may be the same as or different from the light shielding element 154.

Other elements of the fourth embodiment are the same as those in the third embodiment, and detailed description thereof is omitted.

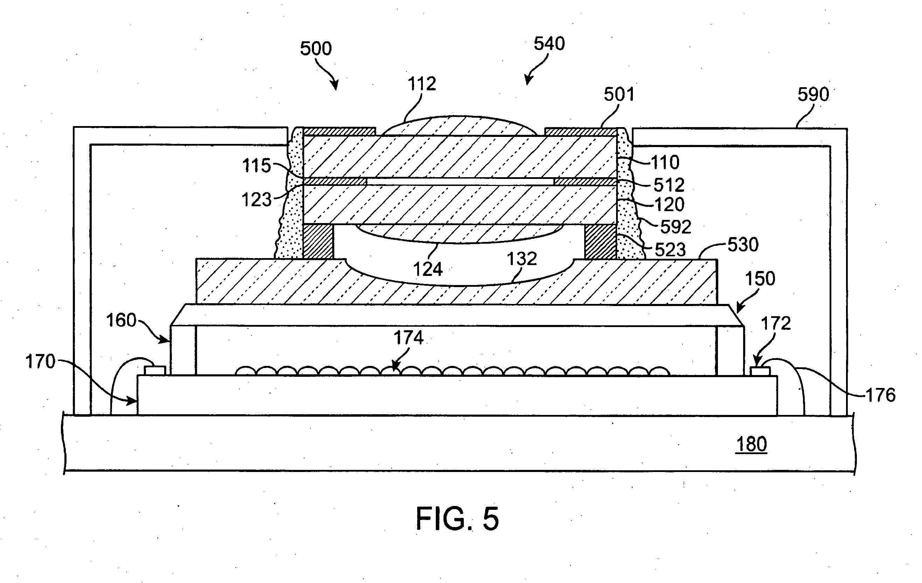

In a camera system 500 according to the fifth embodiment, as illustrated in FIG. 5, a housing 590, e.g., an opaque housing, may protect the wire bonds 176 as well as contain an encapsulant material 592. A third substrate 530 of an optics stack 540 may extend beyond the first and second substrates 110, 120. The third substrate 530 may include features to further aid in restraining the encapsulant 592. The resultant stepped structure of optics stack 540 may be formed, for example, by securing the first and second substrates 110, 120 together on a wafer level, singulating the secured pairs, and securing the singulated pairs to the third substrate 530, or by securing all three substrates 110, 120, 530, before singulation, and singulating by dicing, e.g., with different blade widths from different surfaces of the secured substrates. Here, the encapsulant 592 may also serve to protect elements of the camera system 500 from moisture and other environmental contaminants. Other elements of the fifth embodiment are the same as those in the first embodiment, and detailed description thereof is omitted.

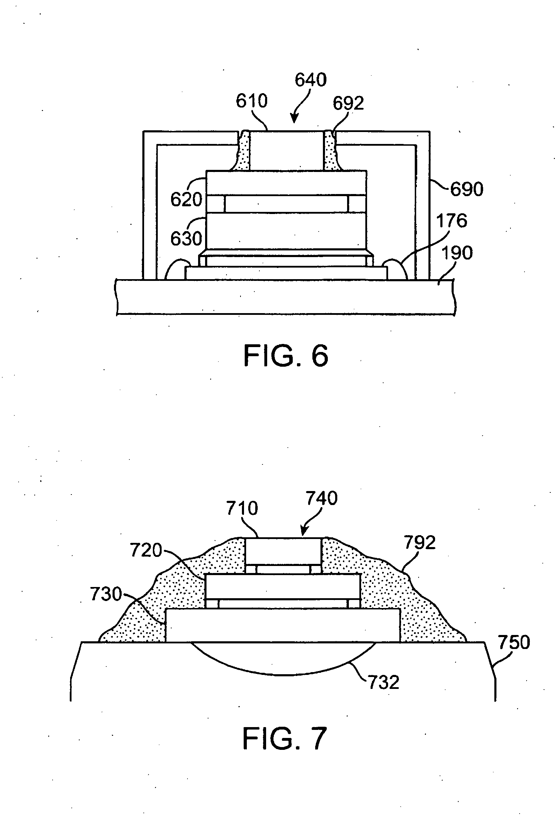

In a camera system 600 according to the sixth embodiment, as illustrated in FIG. 6, a housing 690, e.g., an opaque housing, may protect the wire bonds 176 as well as contain an encapsulant material 692. A first substrate 610 of an optics stack 640 may have a smaller surface area than the second and third substrates 620, 630. The second substrate 620 may include features to further aid in restraining the encapsulant 692. The resultant stepped structure of optics stack 640 may be formed, for example, by securing a singulated first substrate to secured second and third substrates or by securing all three substrates before singulation, and singulating by dicing, e.g., with different blade widths from different surfaces of the secured substrates. Here, the encapsulant 692 may also serve to hermetically seal the camera system 600. The optics stack 640, as with any of the other embodiments, may be any suitable optics stack.

In a camera system 700 according to the seventh embodiment lying outside the scope of the present invention, as illustrated in FIG. 7, a stepped optics stack 740 may be used with just an encapsulant 792. This stepped optics stack 740 may help restrain the encapsulant 792 to insure good coverage thereof. In the particular optics stack 740 of the seventh embodiment, a first substrate 710 may be smaller than a second substrate 720, which, in turn, may be smaller than a third substrate 730.

A cover structure 750 may include a concave lens 732 therein. The cover structure 750 may include features to further aid in restraining the encapsulant 792. The resultant stepped structure of optics stack 740 may be formed, for example, by singulating each of the first through third substrates and then securing then together, singulated the secured pairs or by securing all three substrates before singulation, and singulating by dicing, e.g., with different blade widths from different surfaces of the secured substrates.

A camera system 800 according to the eighth embodiment, as illustrated in FIG. 8, may include an optics stack 840 including first through third substrates as in the first embodiment or as in the fifth embodiment. However, spacer 512' between the first and second substrates and spacer 523' between the second and third substrates may not extend to an edge of these substrates. This may be useful when the spacers 512', 523' are not made of materials that typically are subject to singulation, e.g., dicing. For example, when the spacers 512', 523' are SU8, these spacers 512', 523' may be provided such that they are out of the separation path of their respective substrates. An encapsulant 892 may then fill in these gaps between the spacers 512', 523' and an edge of the substrates to reduce stray light. The cover structure 150 may include features 158 to restrain the encapsulant 892.

Exemplary embodiments of the present invention have been disclosed herein, and although specific terms are employed, they are used and are to be interpreted in a generic and descriptive sense only and not for purpose of limitation. For example, while the substrates in the optics stack may all be the same material or may be different materials. When different substrate materials are employed, the refractive index of the light blocking material may be closest to that of a substrate most likely to internally reflect light or may be averaged across the substrates. Accordingly, it will be understood by those of ordinary skill in the art that various changes in form and details may be made without departing from scope of the present invention as set forth in the following claims.

## Claims

1. A camera system, comprising:
an optics stack (140, 540) including two substrates (110, 120) secured together in a vertical direction and an optical system (112, 124) on the two substrates, the two substrates having transparent sides;
a detector on a detector substrate (170);
**characterized in that** the camera system comprises
a housing (190, 590) surrounding the optics stack (140, 540); and
a stray light blocker including an encapsulant (192, 592) between the housing (190, 590) and the optics stack (140, 540), the stray light blocker being directly on at least some transparent sides of the optics stack.

2. Camera system as claimed in claim 1, wherein the at least some sides include sides on a substrate in the optics stack furthest away from the detector substrate.

3. Camera system as claimed in claim 1, wherein the encapsulant is on all transparent sides of the optics stack.

4. Camera system as claimed in claim 1, wherein the encapsulant has an index of refraction that is approximately equal to that of a substrate having the at least some sides.

5. Camera system as claimed in claim 1, wherein one substrate in the optics stack has a smaller surface area than the detector substrate.

6. Camera system according to any of the preceding claims, wherein the encapsulant extends from an upper surface of the optics stack to the detector substrate.

7. Camera system as claimed in claim 1, wherein the detector substrate extends beyond the optics stack in at least one direction.

8. Camera system as claimed in claim 7, further comprising bonding pads on the detector substrate extending beyond the optics stack.

9. Camera system as claimed in claim 8, further comprising a substrate having elements to be electrically connected to the bonding pads.

10. Camera system as claimed in claim 9, the encapsulant covers the bonding pads and electrical connectors between the bonding pads and the detector substrate.

11. Camera system according to any of the preceding claims, further comprising features on the detector substrate restraining the encapsulant.

12. Camera system according to any of the preceding claims, wherein the housing surrounding the optics stack extends down to the detector substrate.

13. Camera system according to any of the preceding claims, wherein substrates in the optics stack are not coextensive.

## Patentansprüche

1. Kamerasystem, umfassend:
einen Optikstapel (140, 540) umfassend zwei Substrate (110, 120), die in einer Vertikalrichtung zusammengehalten sind, und ein optisches System (112, 124) auf den zwei Substraten, wobei die zwei Substrate durchsichtige Seiten aufweisen;
einen Detektor auf einem Detektorsubstrat (170);
**dadurch gekennzeichnet, dass** das Kamerasystem folgendes umfasst:
ein Gehäuse (190, 590), welches den Optikstapel (140, 540) umgibt; und
einen Streulichtblocker umfassend einen Verkapselungsstoff (192, 592) zwischen dem Gehäuse (190, 590) und dem Optikstapel (140, 540), wobei sich der Streulichtblocker auf zumindest einigen durchsichtigen Seiten des Optikstapels befindet.

2. Kamerasystem nach Anspruch 1, wobei die zumindest einigen Seiten Seiten auf einem Substrat in dem Optikstapel, der sich von dem Detektorsubstrat am weitesten entfernt befindet, umfassen.

3. Kamerasystem nach Anspruch 1, wobei sich der Verkapselungsstoff auf allen durchsichtigen Seiten des Optikstapels befindet.

4. Kamerasystem nach Anspruch 1, wobei der Verkapselungsstoff einen Brechungsindex aufweist, welcher dem Brechungsindex eines Substrats, welches die zumindest einigen Seiten aufweist, annähernd gleich ist.

5. Kamerasystem nach Anspruch 1, wobei ein Substrat in dem Optikstapel einen kleineren Flächenbereich als das Detektorsubstrat aufweist.

6. Kamerasystem nach einem der vorgehenden Ansprüche, wobei der Verkapselungsstoff sich von einer oberen Oberfläche des Optikstapels bis zum Detektorsubstrat erstreckt.

7. Kamerasystem nach Anspruch 1, wobei sich das Detektorsubstrat über den Optikstapel hinaus in zumindest eine Richtung erstreckt.

8. Kamerasystem nach Anspruch 7, ferner umfassend Klebepads auf dem Detektorsubstrat, welche sich über den Optikstapel hinaus erstrecken.

9. Kamerasystem nach Anspruch 8, ferner umfassend ein Substrat, welches mit den Klebepads elektrisch zu verbindende Elemente aufweist.

10. Kamerasystem nach Anspruch 9, wobei der Verkapselungsstoff die Klebepads und die elektrischen Verbinder zwischen den Klebepads und dem Detektorsubstrat überdeckt.

11. Kamerasystem nach einem der vorgehenden Ansprüche, ferner umfassend Merkmale auf dem Detektorsubstrat, die den Verkapselungsstoff beschränken.

12. Kamerasystem nach einem der vorgehenden Ansprüche, wobei das Gehäuse, welches den Optikstapel umgibt, sich nach unten bis zum Detektorsubstrat erstreckt.

13. Kamerasystem nach einem der vorgehenden Ansprüche, wobei Substrate in dem Optikstapel nicht flächengleich sind.

## Revendications

1. Système de caméra, comprenant:
un empilement d'éléments optiques (140, 540) comprenant deux substrats (110, 120) fixés l'un à l'autre dans une direction verticale et un système optique (112, 124) sur les deux substrats, les deux substrats ayant des côtés transparents;
un détecteur sur un substrat de détecteur (170);
**caractérisé en ce que** le système de caméra comprend
un boîtier (190, 590) entourant l'empilement d'éléments optiques (140, 540); et
un bloqueur de lumière parasite comprend un agent d'encapsulation (192, 592) entre le boîtier (190, 590) et l'empilement d'éléments optiques (140, 540), le bloqueur de lumière parasite étant arrangé directement sur au moins certains des côtés transparents de l'empilement d'éléments optiques.

2. Système de caméra selon la revendication 1, dans lequel les au moins certains des côtés comportent des côtés sur un substrat dans l'empilement d'éléments optiques le plus éloigné du substrat de détecteur.

3. Système de caméra selon la revendication 1, dans lequel l'agent d'encapsulation est présent sur tous les côtés transparents de l'empilement d'éléments optiques.

4. Système de caméra selon la revendication 1, dans lequel l'agent d'encapsulation présente un indice de réfraction qui est approximativement égal à celui d'un substrat comportant les au moins certains des côtés.

5. Système de caméra selon la revendication 1, dans lequel un substrat dans l'empilement d'éléments optiques présente une aire de surface inférieure à celle du substrat de détecteur.

6. Système de caméra selon l'une quelconque des revendications précédentes, dans lequel l'agent d'encapsulation s'étend à partir d'une surface supérieure de l'empilement d'éléments optiques au substrat de détecteur.

7. Système de caméra selon la revendication 1, dans lequel le substrat de détecteur s'étend au-delà de l'empilement d'éléments optiques dans au moins une direction.

8. Système de caméra selon la revendication 7, comprenant en outre des plages de liaison sur le substrat de détecteur s'étendant au-delà de l'empilement d'éléments optiques.

9. Système de caméra selon la revendication 8, comprenant en outre un substrat présentant des éléments à relier de manière électrique aux plages de liaison.

10. Système de caméra selon la revendication 9, dans lequel l'agent d'encapsulation recouvre les plages de liaison et des connecteurs électriques entre les plages de liaison et le substrat de détecteur.

11. Système de caméra selon l'une quelconque des revendications précédentes, comprenant en outre des fonctions sur le substrat de détecteur retenant l'agent d'encapsulation.

12. Système de caméra selon l'une quelconque des revendications précédentes, dans lequel le boîtier entourant l'empilement d'éléments optiques s'étend vers le bas au substrat de détecteur.

13. Système de caméra selon l'une quelconque des revendications précédentes, dans lequel les substrats dans l'empilement d'éléments optiques ne sont pas coextensifs.
